# EUROPEAN PATENT APPLICATION

(11) **EP 3 822 389 A1**
(43) Date of publication of application: **19.05.2021**
(21) Application number: 19208861.5
(22) Date of filing: 13.11.2019
(51) Int. Cl.: C23C 16/04, C23C 16/54, C23C 16/455

(54) **AREA SELECTIVE ATOMIC LAYER DEPOSTION METHOD AND TOOL**

(71) Applicant: Nederlandse Organisatie voor toegepast- natuurwetenschappelijk Onderzoek TNO, 2595 DA 's-Gravenhage (NL)
(72) Inventor: MAMELI, Alfredo, 2595 DA's-Gravenhage (NL); FAWZY, Ahmed, 2595 DA's-Gravenhage (NL); ROOZEBOOM, Freddy, 2595 DA's-Gravenhage (NL); POODT, Paulus Willibrordus George, 2595 DA's-Gravenhage (NL)
(74) Representative: V.O.

(57) **Abstract**

The present disclosure concerns an atomic layer deposition device for area-selective deposition of a target material layer onto a deposition area of a substrate surface further comprising a non-deposition area. In use the substrate is conveyed along a plurality of deposition and separator spaces including at least two gas separator spaces provided with at least a separator gas inlet and a separator drain for, in use exposing the substrate to a separator gas flow. Wherein at least one of the gas separator spaces forms a combined separator-inhibitor gas flow comprising a separator gas and inhibitor moieties. The inhibitor moieties selectively adhering to the non-deposition area to form an inhibition layer reducing adsorption of precursor moieties. In a preferred embodiment the device includes a backetching space to increase selectivity of the deposition process.

## Description

### TECHNICAL FIELD AND BACKGROUND

The present disclosure relates to atomic layer deposition (ALD) tools and methods. More specifically, the present disclosure relates to area-selective deposition of atomic layers, in particular to high throughput deposition tools and methods including spatial ALD.

Atomic layer deposition is known as a method for depositing a monolayer or sub-monolayer of target material. Atomic layer deposition differs from for example chemical vapour deposition in that atomic layer deposition takes at least two process steps. A first one of these process steps typically involves binding or chemisorption of a precursor moiety onto the substrate surface. Although known methods may deposit target layers with good conformity, they lack an ability to provide spatial control over deposition areas and as such are less suitable for area-selective deposition of target material layers particularly in combination with large-scale or high-throughput deposition methods. In ACS Nano 2017, 11, 9303-9311, A. Mameli et al., a so-called single-wafer process is described that allows for selective deposition of SiO₂ on GeO₂, SiNₓ, SiO₂, and WO₃, in the presence of Al₂O₃, TiO₂, and HfO₂ surfaces using acetylacetone as inhibitor, BDEAS (H₂Si[N(C₂H₅)₂]₂) as precursor and an O₂ plasma as co-reactant. The process relies on a vessel type vacuum reactor in which a substrate is sequentially exposed to these three exposure steps. Between each exposure step the reactor is evacuated. Direct integration of three exposure steps in known high-throughput deposition tools such as spatial ALD is expected to lead to an increased use of process gasses. The present disclosure aims to reduce these and/or other disadvantages such as the elimination of long evacuation (or purge) steps in conventional vacuum-based ALD.

### SUMMARY

Aspects of the present disclosure relate to an atomic layer deposition device for area-selective deposition of a target material layer onto a deposition area of a substrate surface further comprising a non-deposition area. The device is provided with at least a process gas injection head and a conveying system arranged to provide relative movement, including but not limited to linear reciprocation and rotation, between the substrate surface and the process gas injection head in a direction along the substrate surface to form a conveying plane along which, in use, the substrate surface passes a plurality of deposition and gas separator spaces defined between the process gas injection head and the substrate surface. During conveying the head and substrate surface are preferably separated across a distance. The plurality of deposition and separator spaces includes at least:
- a first deposition space provided with a precursor supply and a precursor drain for providing a precursor gas flow from the precursor supply via the first deposition space to the drain;
- a second deposition space provided with a co-reactant supply and a co-reactant drain for providing a co-reactant gas flow from the co-reactant supply via the second deposition space to the drain; and
- at least two separator spaces wherein each of the at least two separator spaces is provided with at least a separator gas inlet and a separator drain for providing a separator gas flow from the separator gas inlet via the separator space to the drain.

A first gas separator space of the at least two separator spaces is preferably positioned adjacent to the first deposition space. A second gas separator space is preferably positioned adjacent to the first deposition space opposite the first gas separator space and adjacent to the second deposition space. The process gas injection head is arranged to provide the first gas separator space with a combined separator-inhibitor gas flow comprising a separator gas and inhibitor moieties selectively adhering to the non-deposition area.

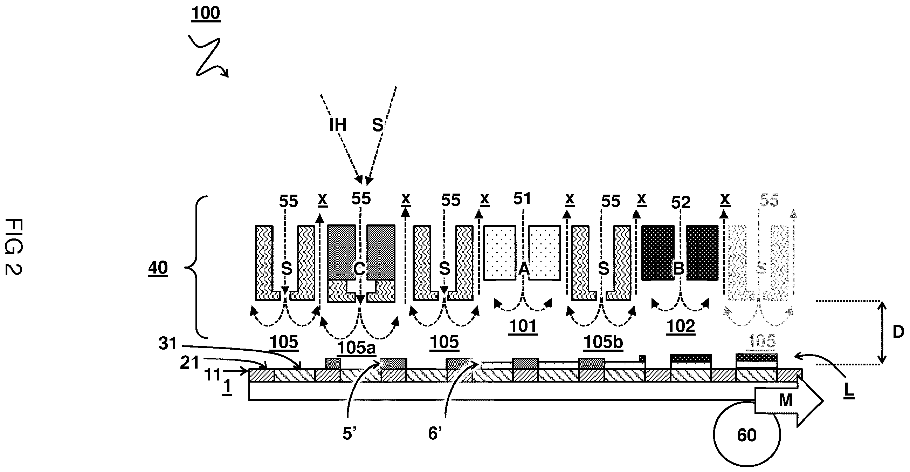

It will be appreciated that the first and second deposition spaces and the at least two separator spaces in use may be interpreted as being bound (in horizontal direction, see e.g. FIG 2) by the substrate surface and the process gas injection head separated at a distance from the substrate surface.

The deposition and separator spaces in use are preferably arranged such that in use the substrate surface is sequentially exposed to at least:
- a combined separator-inhibitor gas flow for adsorbing inhibitor moieties to the pre-defined non-deposition areas of the substrate surface to form an inhibitor layer;
- the precursor gas flow for adsorbing precursor moieties to the pre-defined deposition area of the substrate surface.
- a second gas separator gas flow to reduce gas phase intermixing of the precursor and co-reactant, to reduce intermixing of reactive moieties comprised in the precursor and co-reactant gas flows; and
- the co-reactant gas flow to allow co-reactant moieties comprised therein to react with adsorbed precursor moieties to form a first layer of target material and to complete, what may be understood to be a first atomic layer deposition process cycle.

By first exposing the substrate to inhibitor moieties adsorption of precursor moieties to the non-deposition area may be reduced, preferably prevented. The provided device may be understood to be particularly beneficial for high-throughput and/or large-area selective layer deposition. It will be appreciated that presence of additional separation and/or deposition spaces is not precluded. As will become clear herein, the head may be arranged to provide additional or a reduced number of process flows.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A and B schematically illustrate a target material layer selectively deposited on the pre-defined deposition areas of a substrate;
FIG 2 schematically illustrates a cross-section side view of an embodiment of an atomic layer deposition device;
FIG 3 schematically illustrates a cross-section side view of a further embodiment of an atomic layer deposition device;
FIG 4 schematically illustrates a cross-section side view of an embodiment of a process gas injection head of an atomic layer deposition device;
FIG 5 schematically illustrates a cross-section side view of an even further embodiment of an atomic layer deposition device;
FIG 6 schematically illustrates a cross-section side view of yet a further embodiment of an atomic layer deposition device;
FIGs 7A and B schematically illustrate embodiments of area-selective atomic layer deposition process cycles;
FIGs 8A and B schematically illustrate further embodiments of area selective atomic layer deposition process cycles;
FIGs 9A schematically illustrates a cross-sectional partial side view of yet an even further embodiment of an atomic layer deposition device;
FIG 9B schematically illustrates various ALD process conditions;
FIG 10A displays an observed time-dependent increase in deposited layer thickness on deposition and non-deposition areas per ALD process cycle;
FIG 10B displays a time trace of an observed increase in deposited layer thickness per ALD process cycle for a process including (back-)etching; and
FIG 11 displays observed atomic composition of a substrate comprising deposition and non-deposition areas exposed to an area selective material layer deposition process.

### DETAILED DESCRIPTION

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise, it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

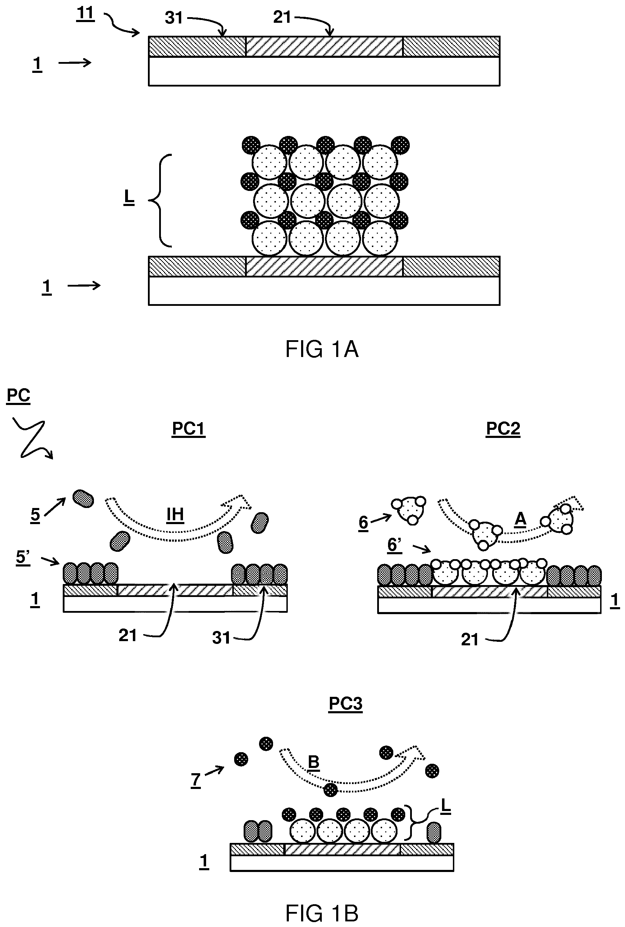

As used herein the term 'deposition area' may be understood to refer to 'growth area'. Likewise, the term 'non deposition area' may be understood to refer to 'non growth area'. FIGs 1A and B schematically illustrate a target material layer L selectively deposited on the deposition area 21 of a substrate 1 surface 11. It is an aspect of the present disclosure to provide a device suitable for selectively depositing a layer of a target material on the deposition area 21, e.g. a pre-defined deposition area, of substrate surface 11. As schematically indicated the material layer may be understood to be an atomic layer deposited in an atomic layer deposition process. Accordingly the device and method according to the present invention relate to atomic layer deposition (ALD) devices and/or ALD methods.

The device and method according to the invention make use of a different physico-chemical affinity of various moieties towards the deposition area 21 and non-deposition area 31 on the substrate surface 11 to avoid or at least reduce deposition of a target material layer L on the non-deposition area 31.

As layers formed by ALD-processes may be understood to be a result of surface reactions it will be appreciated that the non-deposition and deposition area are typically formed of different materials and/or materials with surface binding sites with different chemical reactivity.

In the example as shown in FIG 1A (bottom) the layer L may be understood to be formed after completion of three process cycles PC1, PC2, PC3, wherein each layer is formed from a reaction between an adsorbed precursor moiety 6', e.g. molecule, and a co-reactant molecule 7, and whereby inhibitor moieties 5 preferentially form a barrier layer, i.e. inhibition layer, of adsorbed inhibitor moieties 5' on the non-deposition area 31 are of the substrate 1.

In the example a substrate 1 having spatially separate non-deposition 31 and deposition areas is exposed to first process step PC1. In the first process step the substrate is exposed to an inhibitor gas flow IH comprising inhibitor moieties 5 for a time suitable to allow formation of an inhibition layer on the non-deposition area 31. The inhibitor is selected to partake in a surface reaction with sites at the surface of the non-deposition area 31 to form a layer thereon to limit other molecules, e.g. precursor moieties, from reaching and/or reacting with the surface. In the reaction by-products, e.g. ligands, may be formed which preferably do not bind to the surface and which are, if present, preferably removed from the direct vicinity of the substrate along with any remaining excess inhibitor moieties, e.g. by evacuating or purging a reaction chamber. In following process steps PC2 and PC3 the substrate is, in line with conventional ALD process exposed to a process flow A comprising precursor moieties and a process flow B comprising co-reactant moieties. As a result of a reaction between an adsorbed precursor and a co-reactant an atomic layer may be preferentially formed resulting in an effectively preferential deposition of the layer on the deposition area 21. The thickness of the deposited layer may be increased with by increasing the repeatedly exposing the substrate to precursor and co-reactant flows, e.g. by repeating step PC1, PC2, and PC3 and/or only PC2 PC3 if the inhibitor layer is not affected by the steps described in PC2 and PC3. A rate of layer formation at the non-deposition area may remain limited at least so long as the blocking properties of the inhibition layer remain sufficient. As indicated in the example inventors found that the blocking properties of the inhibition layer may degrade, particularly upon with increasing number of exposure cycles, e.g. by temperature-induced desorption of the inhibitor moieties and/or by side-reactions, e.g. with the co-reactant.

A publication by A. Mameli et al, in ACS Nano 2017, 11, 9303-9311 describes a process for area-selective ALD. Authors describe that this process allows for selective deposition of SiO₂ on GeO₂, SiNₓ, SiO₂, and WO₃, in the presence of Al₂O₃, TiO₂, and HfO₂ surfaces using acetylacetone as inhibitor, BDEAS (H₂Si[N(C₂H₅)₂]₂) as precursor and an O₂ plasma as co-reactant. The process relies on a vessel type vacuum reactor in which a substrate is sequentially exposed to three exposure steps. Between each exposure step the reactor is evacuated/purged.

According to a first aspect of the present disclosure there is provided an atomic layer deposition device for area-selective deposition of a target material layer onto a deposition area of a substrate surface further comprising a non-deposition area. The provided device may be understood to be particularly beneficial for high throughput and/or large-area layer deposition.

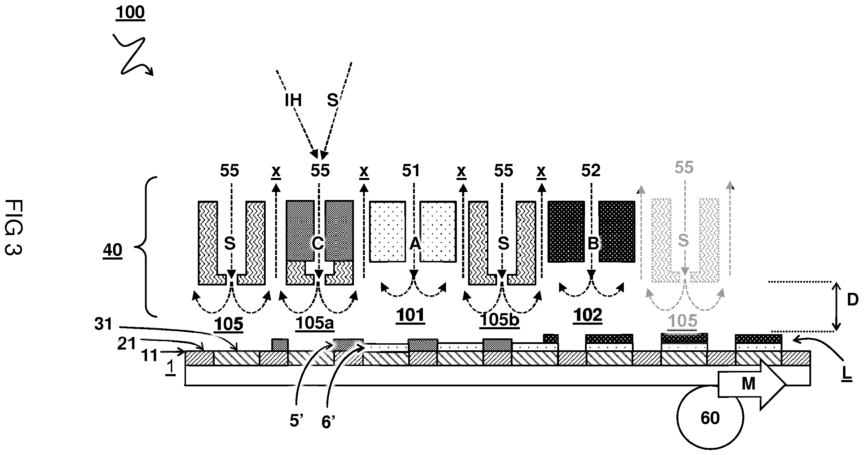

FIG 2 and 3 schematically illustrate partial cross-section side views of embodiments of an atomic layer deposition device 100 according to the first aspect. In the figures a substrate 1 having a substrate surface 11 further comprising a plurality of deposition- 21 and non-deposition areas 31 is separated at a distance D from a process gas injection head 40 of the atomic layer deposition device 100, further comprising at least a conveying system 60 for providing relative movement M between the substrate surface and the process gas injection head. Between the process gas injection head 40 and the substrate surface 11 there is provided: a first deposition space 101, provided with a precursor supply 51 and a precursor drain x for providing a precursor gas flow A from the precursor supply via the first deposition space to the drain; a second deposition space 102 provided with a co-reactant supply 52 and a co-reactant drain for providing a co-reactant gas flow B from the co-reactant supply via the second deposition space to the drain; and separator spaces 105, 105a, 105b. The separator spaces 105, 105a, 105b are provided with a separator gas inlet 55 and a separator drain x for providing a separator gas flow S from the separator gas inlet via the separator space to the drain. The process gas injection head is arranged to provide the first gas separator space 105a with a combined separator-inhibitor gas flow C comprising a separator gas flow and an inhibitor gas flow IH.

As, in use, the substrate surface passes the first gas separator space 105a the substrate is exposed to inhibitor moieties comprised in the combined separator-inhibitor gas flow C. As indicated, the inhibitor moieties adhere (chemisorb) to the non-deposition area of the substrate surface 11 to form an inhibitor layer 5'. Excess inhibitor moieties are carried away to an adjacent drain along with the combined separator-inhibitor gas flow C.

As, in use, the substrate passes the first deposition space 101 the substrate is exposed to the precursor gas flow A. The precursor moieties comprised in the precursor gas flow A adhere (chemisorb) to available binding sites on the substrate surface 11 to form an adsorbed precursor layer 6'. Excess precursor moieties 6 are carried away to an adjacent drain along with the precursor gas flow A.

As, in use, the substrate passes the second deposition space 102 the substrate is exposed to the co-reactant gas flow B. The co-reactant moieties 7 (not shown) comprised therein react with the adsorbed precursor layer 6' to form a first layer of the target material layer L. Excess co-reactant is carried away to an adjacent drain along with the co-reactant gas flow B.

It will be appreciated that presence of additional separation and/or deposition spaces is not precluded. As will become clear herein, the head may be arranged to provide additional or a reduced number of process flows including but not limited to the omission removal or addition of separator gas flows S, as indicated in the figures by grayed-out elements.

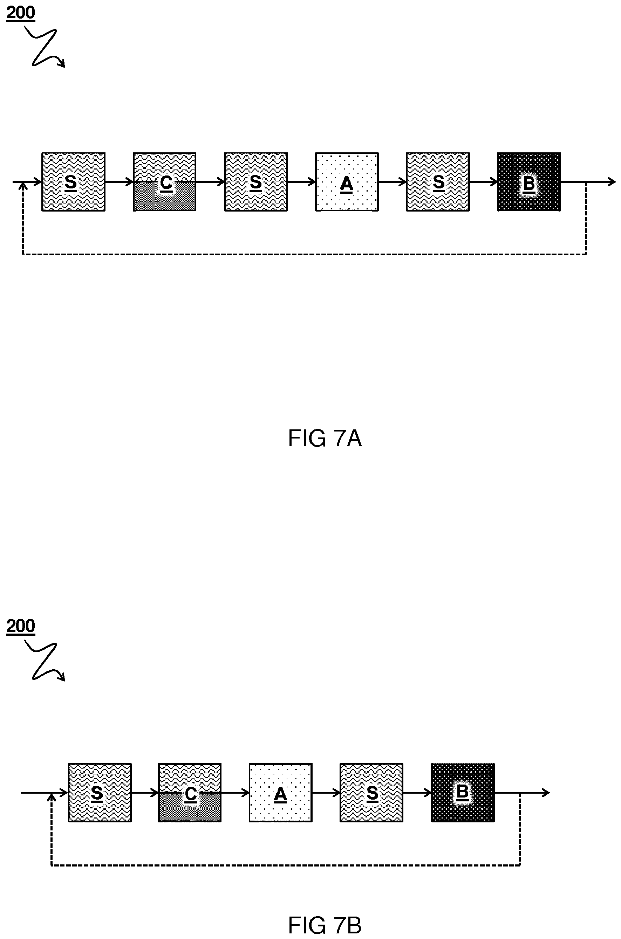

In the embodiment as shown in FIG 2 the spaces 101, 102, 105, 105a, 105b, are positioned such that a sample being processed by the device is in order exposed to a separator gas flow S, the combined separator-inhibitor gas flow C, a further separator gas flow S, the precursor gas flow A, a further separator gas flow S, and the co-reactant gas flow B. The resulting exposures may be referred to as to complete an exemplary first ALD process cycle. FIG 7A schematically illustrates a process cycle corresponding to an area-selective atomic layer deposition method 200 in which a sample is exposed to a combined separator-inhibitor gas flow C after being exposed to a separator gas flow S and before being exposed to a further separator gas flow S, the precursor gas flow A, a yet further separator gas flow S and the co-reactant gas flow B.

The separator gas flow S provided between respective inhibitor, precursor and co-reactant exposures are provided to prevent intermixing of reactive moieties comprised the corresponding flows.

The embodiment as shown in FIG 3 and corresponding method as schematically depicted in FIG 7B, differs from the embodiment shown in FIG 2 in that the separator space 105 between separator space 105a and deposition space 101 is omitted. FIG 7B schematically illustrates a process cycle corresponding to an area-selective atomic layer deposition method 200 in which a sample is exposed to a separator gas flow S before being exposed to the combined separator-inhibitor gas flow C, the precursor gas flow A, a further separator gas flow S and the co-reactant gas flow B.

Arranging the deposition and separator spaces as specified may allow the surface to sequentially pass the first gas separator space 105a, the first deposition space 101, the second gas separator space 105b, and the second gas separator space 105b to complete an atomic layer deposition process cycle PC.

As used herein the precursor gas flow A may be understood to comprise precursor moieties 6 to participate in a self-limiting reaction with reactive groups (e.g. sites) on the surface of the substrate and/or of pre-deposited layers thereon to form a precursor layer. Preferably the precursor gas flow A also comprises an inert carrier gas. The inert carrier gas may be used to carry precursors through the system and/or to set a desired precursor concentration at the first deposition space 101. In a preferred embodiment, the precursor gas flow A comprises a mixture of precursor moieties and preferably an inert carrier gas to form a target material layer L formed of a mixture of constituents, e.g. a target material layer L comprising a mixture of metal elements in a pre-determined ratio.

The separator gas flow S is typically formed of inert gas species, similar to, preferably the same as, the carrier gas species comprised in the precursor and/or co-reactant gas flows A and B, respectively.

As specified, the combined separator-inhibitor gas flow C comprises a separator gas and inhibitor moieties 5. The inhibitor is selected to preferentially adhere/bind to the non-growth area, preferably exclusively adheres/binds to available adsorption sites of the material of the non-deposition area to form an inhibitor layer 5.

The inhibitor layer preferably completely covers all available sites of the non-deposition area 31 to form an inhibitor layer covering all available binding sites of the non-deposition area. The inhibitor reaction with surface sites at the non-deposition area 31 is preferably a self-limiting reaction, e.g. a reaction leading to the formation of a dense, fully covering monolayer. Alternatively, the inhibitor moieties may partake in a reaction with in which the inhibitor layer thickness increases with contact time and/or concentration, e.g. a surface-bound polymerization type reaction.

By forming an inhibitor layer 5' may reduce, preferably avoid, further adhesion of moieties, including but not limited to precursor moieties. Such specific adherence may advantageously be achieved for substrates wherein the growth and non-growth areas are formed of different materials and/or materials with surface sites with different affinity (i.e. reactivity towards the inhibitor moieties).

By combining inhibitor moieties (e.g. molecules and/or reactive plasma species) into a separator gas flow the first gas separator space 105a may be understood to form a combined separator-inhibitor-deposition space. Compared to an atomic layer deposition device 100 wherein the an inhibitor flow is provided from a dedicated outlet, e.g. in a dedicated deposition space, the device providing a combined gas-separator-inhibitor flow C may be faster, cheaper and/or more efficient to operate. For example, integrating inhibitor moieties into a separator flow may reduce (eliminate) a need for dedicated separator gas flow thus reducing the amount of inert carrier gas used during the deposition process. Further, integrating inhibitor moieties into a separator flow may reduce a dimension, e.g. dimension along a processing direction, of the head 40 and/or reduce a footprint of the atomic layer deposition device 100. Advantageously, this may reduce dwell time of a substrate 1, thus facilitating operation with a comparatively improved process speed, e.g. in a continuous reel-to-reel process, and or allow for inclusion of a further processing unit in a device with a given footprint.

The co-reactant gas flow comprises one or more co-reactants, preferably carried by an inert carrier gas, to participate in a self-limiting reaction with precursor moieties within the precursor layer to form a first layer of the target material. Optionally, the co-reactant gas flow comprises a mixture of co-reactant moieties and preferably an inert carrier gas to form a target material layer formed of a mixture of constituents, e.g. a target material layer comprising metal elements bound to a mixture of heteroatoms, e.g. O and N, in a pre-determined ratio.

In general terms, inventors found that the selection of what inhibitor would work on which surface is mostly dictated by surface acidity and basicity as well as basic/acid character of the inhibitor. For details, reference is made to a publication by A. Mameli et al. in ACS Nano 2017, 11, 9303-9311, which is hereby incorporated by reference. In the case of oxidic surfaces, inventors find interaction between a surface and a potential inhibitor molecule is determined by their chemical affinity, which can be derived from the electronegativity of the cation in the oxide (as defined e.g. by Linus Pauling) and the polarizability of the X-Y bonds, typically built in the inhibitor molecule's ligand groups. This can be translated in the elements' or compounds' Bronsted acidity (proton attraction- or repulsion-based) or Lewis acidity (electron attraction- or repulsion-based). Inventors found that the following classes of inhibitors may selected: Ketones, e.g. acetone, acetophenone, methyl propyl ketone, etc; Beta-diketones, preferably 1-2, diketones such as diacetyl, acetylacetone, hexafluoroacetyl-acetone, etc; Primary, secondary, and tertiary alcohols, but preferably tertiary alcohols; Carboxylic acids such as ethylbutyric acid, and trimethylacetic acid; Primary, secondary, and tertiary amines such as methylamine, dimethylamine, and trimethylamine; Diamines such as ethane diamine, and small alkyl chain (Cₙ with 1<n<6) thiols such as ethane dithiol.

Preferable the co-reactant moieties 7 are dosed to the substrate surface as plasma species. For example, an oxygen-, nitrogen-, or hydrogen plasma, or mixtures thereof.

Plasma moieties are known to be highly reactive and accordingly provision of plasma moieties may allow more efficient operation of the deposition tool and process. Associated benefits include but are not limited to: operation at lower temperature e.g. in a range between 10 °C and 150 °C, e.g. between 20 °C and 100 °C; operation at lower co-reactant concentrations; operation using shorter process time; e.g. faster relative motion and/or smaller deposition spaces, which may result in a higher reaction rate at a given combination of temperature and concentration.

Accordingly in a preferred embodiment the device comprises a plasma generator. The plasma generator is preferably a remote plasma generator allowing plasma moieties to be remotely generated plasma moieties, e.g. at a location within the process gas injection head 40, to be transported with an inert carrier gas to the deposition space. For example, the plasma generator may be arranged to act on the co-reactant gas flow B at an upstream position of the second deposition space 102. Reference is made to WO2015199539 which is hereby incorporated by reference.

By transporting remotely generated plasma moieties to the deposition space the ALD reaction may be performed effectively without directly exposing the substrate surface and layers comprised thereon to possible damaging plasma generating conditions, including locally exposing the substrate to high temperatures and/or plasma discharges.

Further plasma species are comparatively short-lived. Use of short-lived plasma species may reduce a risk of undesired gas-phase reactions, e.g. with a moieties originating from an adjacent deposition space.

In some embodiments the co-reactant moieties dot not include plasma species, i.e. are formed of molecular co-reactant moieties.

Molecular co-reactant moieties typically have a lower reactivity. Inventors believe that the high reactivity of plasma species may result in a decomposition reaction with adsorbed inhibitor species at non-deposition areas 31. Reaction with plasma species may cause a gradual loss of inhibition function of the adsorbed inhibitor species e.g. upon repeated exposed of the substrate surface 11 to a plasma flow. As the atomic layer deposition device 100 allows exposing the substrate surface 11 to a combined gas-separator-inhibitor flow C such loss of inhibiting function may be mitigated.

In a preferred embodiment the process gas injection head may be understood to be arranged to expose the substrate surface 11 to an atomic layer deposition process cycle including: an exposure to the combined gas-separator-inhibitor flow, followed by an exposure to the precursor gas flow, followed by an exposure to a separator gas flow, followed by an exposure to a co-reactant gas flow.

It will be appreciated that devices and/or methods, e.g. process cycles are not to be construed to be limited to preclude inclusion of additional process steps or components nor to any specific order, unless otherwise specified. The device and/or methods may comprise alternate or additional components or steps which may be included before, after or in between specified components and/or process steps as will be exemplified and clarified herein below. Optionally, the head may be arranged to perform the steps in the exact order as specified, i.e. without additional exposures between specified steps.

In a particular embodiment, e.g. as shown in FIG 3, the combined separator-inhibitor gas flow C is directly followed by the precursor gas flow A, i.e. without a separator gas flow S reducing intermixing of the precursor gas flow A and combined separator-inhibitor gas flow C.

In another particular embodiment e.g. as shown in FIG 2, a third separator space 105 may be provided. As such, the head is or may be understood to be arranged to expose the substrate surface 11 to an atomic layer deposition process cycle formed of: an exposure to a separator gas flow S; followed by an exposure to the combined gas-separator-inhibitor flow C, followed by an exposure to a further separator gas flow S, followed by an exposure to the precursor gas flow A, followed by an exposure to a further separator gas flow S, followed by an exposure to a co-reactant gas or plasma flow B, e.g. as schematically shown in FIG 7A which will be detailed on later.

In embodiments arranged to allow intermixing of the precursor gas flow A and the combined separator-inhibitor gas flow C, e.g. as in FIG 3, the inhibitor moiet(y)(ies) and the (one or more) precursor moiet(y)(ies) comprised therein are preferably selected to be mutually compatible. Mutually compatible may be understood to include mutually stable compounds, e.g. in a physico-chemical sense. Compounds which are mutually stable, e.g. in a physico-chemical sense, may be understood to not undergo gas-phase (i.e. homogeneous) reactions or heterogeneous reactions with the surface, i.e. they essentially do not react with each other or at least comparatively slowly in time scale of the exposure. For example, the inhibitor and precursor do not (or comparatively slowly in time scale of the exposure) react with each other. At least not in such a way that any non-gaseous reaction products are formed. Non-gaseous reaction products may contaminate the substrate surface 11, and/or in/outlets of deposition spaces, separator spaces, and/or drains. In other words, in the gas phase the inhibitor and the precursor preferably do not (chemically) react. A reaction between the inhibitor and the precursor may be tolerated if the reaction products may be carried away from the substrate in the exhaust, e.g. gaseous and/or vapor phase reaction products.

Inventors found that mixing of precursor and inhibitor may proceed in a non-harmful way, i.e. mixing may be acceptable for processes wherein the inhibitor may comprise structural similarities to the precursor moieties, e.g. to one or more of the ligands comprised therein. For example, dimethylamine may be used as inhibitor in combination with tetrakis(dimethylamido)titanium as titanium precursor moiety. In more general terms all primary, secondary and tertiary amines as well as diamines (for example ethylenediamine) may be suitable as inhibitors provided they all behave as inhibitor, i.e. provided they preferentially bind the non-deposition area 31 of the substrate surface 11.

A more broad range of inhibitors may be selected in processes that use precursors moieties which are comparatively unreactive. E.g. not reactive with H₂O and O₂ at relatively low temperatures (<350 °C). Inventors found that comparatively unreactive precursors (unreactive towards H₂O and O₂ at temperatures below 350 °C) also do not react with common inhibitor moieties. Examples of comparatively unreactive precursors include are all amino-based silicon precursors, e.g. bisdiethylaminosilane (BDEAS), bis(tertiary-butyl-amino)silane (BTBAS), di(sec-butylamino)silane (DSBAS). Conversely, inhibitors that effectively react with the precursor may or will lead to presence of CVD-type reactions (chemical vapor deposition) along with undesired, e.g. uncontrolled, deposition of organic/inorganic hybrid reaction products.

It will be appreciated that the deposition spaces are, in use, defined between a face of the (moving) substrate and a face of the process gas injection head 40. In other words, in use, the substrate surface 11 is separated at a distance D from an opposing face (e.g. bottom face) of the process gas injection head. Inventors found that the separation distances D are preferably within a range between 0.1 and 100 µm, preferably between 0.1 and 10 µm, e.g. 1 or 5 µm, whereby smaller separations reduce a likelihood of intermixing of reactive moieties and/or increases a likelihood of reactive plasma moieties reaching the substrate surface 11 for a desired reaction. Further larger separations are believed to increase a volume of required processes gasses, e.g. separator gas flows (S).

In a preferred embodiment, the device, e.g. the conveying system and/or head, is arranged for repeatedly providing relative movement M between the substrate surface and the process gas injection head. By repeatedly passing (exposing) the substrate surface to the specified deposition and separation spaces the substrate surface may be exposed to a correspondingly increasing number of atomic layer deposition process cycles. By tuning the number of cycles the thickness of the deposited target layer may be tuned. Preferably the system, e.g. the conveying system 60, is arranged to move (pass) substrate 1 along the deposition and separator spaces along a single direction such that upon each pass the substrate surface 11 passes the deposition and separator spaces in the same sequence as in a preceding pass.

In some embodiments, the conveying system 60 may be arranged to facilitate repeatedly exposing the substrate surface 11 to an atomic layer deposition process cycle PC. For example, the conveying system 60 may comprise a drum or conveying belt arranged to repeatedly pass a substrate 1 along the deposition and separator spaces.

Alternatively or in addition, the deposition spaces and separator spaces are arranged along a portion of an arc. Accordingly, in a preferred embodiment the process gas injection head is arranged as a drum, e.g. a rotating drum.

Alternatively or in addition the system , e.g. the conveying system 60 and/or the process gas injection head 40, may be arranged provide relative motion between a substrate and the process gas injection head in a back-and-forth type motion. Back-and forth motion along the process gas injection head may advantageously speed up the layer deposition process.

Without wishing to be bound by theory inventors believe that a pass of a substrate along co-reactant gas flow B comprising a plasma may result in a partial decomposition on the inhibitor layer at the non-deposition area 31. By such so-called plasma chemistry a plasma, e.g. an O₂ plasma can burn (partially or completely) the carbonaceous inhibitor compounds off the surface by combustion-like reactions. Similarly an H₂ plasma can react with carbonaceous moieties to form reaction species such as CH₄, CHₓ, NHₓ and the like. Inventors found that in embodiments wherein upon each pass the substrate surface 11 passes the deposition and separator spaces in the same sequence as in a preceding pass this may pose little problems as the partially decomposed inhibitor layer may be restored upon passing the combined separator-inhibitor gas flow C during a subsequent pass.

In embodiments wherein relative motion between a substrate and the process gas injection head is provided in a back-and-forth type motion, a (partial) layer of the target material may be deposited on the non-deposition area 31 of the substrate surface 11 as during a backward motion the inhibitor layer 5' protecting the non-deposition area 31 may be partially degraded as it passes a precursor gas flow A. Accordingly, embodiments arranged to provide a relative back-and-forth type translation between substrate and process gas injection head 40 preferably use a co-reactant gas flow B with less reactive co-reactant moieties, e.g. in non-plasma form. Alternatively or in addition, the device may be arranged to divert a plasma flow and/or temporality deactivate the plasma generator during a backward translation motion. Further alternatively, there may be provided an additional inhibitor flow, e.g. an additional combined gas-separator-inhibitor flow C, at a position such that the substrate surface 11 is also upon backward translation exposed to inhibitor moieties to restore the inhibitor layer 5' following a plasma exposure. An exemplary atomic layer deposition process cycle PC may be provided using a process gas injection head 40 arranged to in order of a forward translation direction expose the substrate surface 11 to: separator gas flow S; followed by a combined separator-inhibitor flow C; followed by a precursor gas flow A; followed by a second combined separator-inhibitor flow C; and followed by a co-reactant flow B.

It will be appreciated that generally the deposition spaces and/or separator spaces are spatially separated from an adjacent deposition space and/or separator space over a distance less than 25 mm, preferably less, e.g. 20 mm or less e.g. in an range between 5 and 10 mm. Accordingly, in some embodiments a combined dimension of the process gas injection head 40 along the direction of relative movement M is below 100 mm, preferably less, e.g. 50 mm, or less, e.g. in a range between 40 and 20 mm. Providing the first gas separator space 105a with a combined gas-separator-inhibitor flow C advantageously allows reducing a lateral dimension of the process gas injection head 40 compared to a process gas injection head 40 with a dedicated inhibitor space. Having a comparatively smaller process gas injection head 40, e.g. atomic layer deposition device 100 advantageously allows for faster processing speeds. Smaller devices may be particularly beneficial for high-throughput and/or reel-to-reel processes. Reducing a separation distance between adjacent spaces is further believed to improve a quality of the deposited target material layer L as a shorter distance, i.e. shorter time, between adjacent spaces reduces a risk of contamination and/or partial degradation of formed layers.

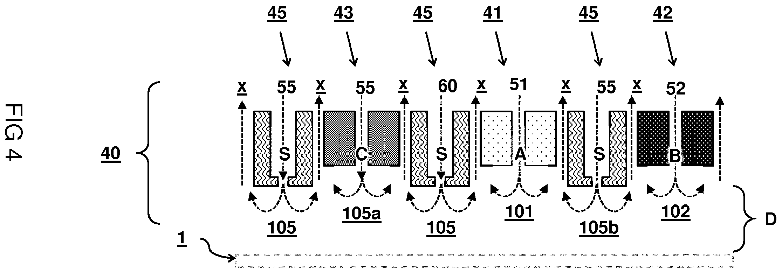

FIG 4 schematically illustrates a cross-section side view of an embodiment, a process gas injection head 40 of an atomic layer deposition device. Together with the process gas injection head 40 there is indicated a substrate 1 position. Between a bottom face of the process gas injection head 40 and the substrate there are indicated the first deposition space 101, the second deposition space 102, and the separator spaces 105, to in use, respectively expose the substrate surface 11 to the precursor gas flow A, the co-reactant gas flow B, and separator gas flow S as well as the combined separator-inhibitor gas flow C. In a preferred embodiment, e.g. as shown, the process gas injection head is formed of an assembly of a plurality of injectors arranged adjacent to each other. The plurality of injectors jointly defining the gas separation, and deposition spaces.

Accordingly, in a preferred embodiment, the plurality of injectors comprises: a precursor gas flow injector 41 forming the precursor supply 51 of first deposition space 101; a co-reactant injector 42 forming the co-reactant supply 52 of the second deposition space 102; and at least two gas separator injectors 45 respectively forming the separator gas inlet 55 of the separator spaces.

It will be appreciated that the gas separator injector forming the inlet of the gas separator space providing the combined gas-separator-inhibitor flow may be understood to be combined gas-separator-inhibitor flow injector. Accordingly in one embodiment, the combined gas-separator-inhibitor flow injector is provided with separate inlets for a separator gas flow and an inlet for inhibitor gas flow. In another or further embodiment, the combined gas-separator-inhibitor flow injector (43) may be provided with a single inlet for a pre-mixed flow of inhibitor and separator gas.

Advantageously the injectors form separate modules which may be combined, e.g. positioned adjacently to each other, to form the process gas injection head 40. Forming the process gas injection head 40 from modular injectors allows an operator to assemble an atomic layer deposition device 100 comprising a purposely arranged set of injectors. Accordingly, an atomic layer deposition device 100 may be formed that is provided with additional deposition or separator spaces. Further the process gas injection head (40) may be provided with additional separators and/or gas bearings.

In accordance with a system comprising a pre-assembled, i.e. non-devisable, process gas injection head 40 the deposition and separation spaces are, in use, defined between the surface of the (moving) substrate and a face of the respective injectors.

In a preferred embodiment, the injectors comprised in the head have a maximum dimension in a direction along the movement direction of 5 mm, preferably 3 mm or less, e.g. in a range between 1 and 2 mm.

In preferred embodiments, the gas separator flow, in use, at least contributes to separating the process gas injection head 40 and the substrate surface 11. In some preferred embodiments the combined flow from the separation spaces and deposition spaces essentially maintain a separation distance between substrate and process gas injection head. Accordingly, in some embodiments the process gas injection head may be understood to be a floating head. Alternatively, the device be arranged to process a floating substrate. In some embodiments, the device comprises one or more additional gas bearings. In some embodiments, the flows in the separation spaces and/or deposition spaces are part of a gas bearing.

It will be appreciated that injectors 41, 42 respectively comprise, the precursor supply 51, co-reactant or plasma supply 52 facing substrate surface 11. The precursor gas flow injector 41 and/or co-reactant gas injector 42 are preferably recessed relative to the separator gas inlet, and/or combined gas-separator-inhibitor inlet (e.g. the face of the gas separator injector). In other words, the apertures from which precursor gas flow A and/or co-reactant gas flow B are provided to the respective deposition spaces are at a comparatively more distant position from the conveying plane relative to the apertures for the separator gas flow S and/or combined gas-separator-inhibitor flow C such as to define comparatively larger deposition spaces. Exposing the substrate surface to a separator gas flow S from a comparatively more close position may reduce a required volume of separator gas required to attain a desired reduction of intermixing of reactive species.

In a preferred embodiment, the atomic layer deposition device comprising a plurality of the deposition and separator spaces as described herein. For example, with reference to FIGs 2, 3, the separator space 105, depicted on the far right of the figure depicted in a lighter graytone (reduced saturation) may be interpreted as a fist space of a subsequent set of separator and deposition spaces the substrate will be exposed to on further relative movement M. A device comprising a plurality of the deposition and separator spaces as described herein, e.g. an atomic layer deposition device 100 comprising a plurality of process gas injection heads 40 or a device with a process gas injection head comprising a multitude of the deposition and separator spaces as specified herein, advantageously allows deposition of a plurality of target material layers upon each single pass of the substrate. Thus enabling faster processing, increasing throughput and/or reducing process time.

In other or further preferred embodiments, the atomic layer deposition device comprises one or more adjacent spaces sharing a drain. By sharing a common drain an overall dimension of the device may be further reduced.

For example, in some embodiments the first deposition space shares a drain with an adjacent separator space. In other or further embodiments, the second deposition space shares a drain with an adjacent separator space. In a preferred embodiment, all adjacent spaces share a drain, e.g. as shown. In embodiments wherein the process gas injection head 40 is formed of a plurality of adjacent injectors the injectors may be provided with separate drains, e.g. drain elements, positioned between adjacent injectors. Alternatively, injectors may be include a drain, e.g. on one side, such that an adjacent injector, e.g. in a plurality of laterally stacked injectors, may share said drain. Said drains may be fluidly connected to a pump to facilitate egress of the respective process flows from the separation and/or deposition spaces. Alternatively, the spaces may be kept at an overpressure relative to the drains. In some embodiments, adjacent injectors are assembled at a lateral distance across a spacer to define a drain, e.g. egress channel.

In another or further preferred embodiment, the atomic layer deposition device 100 is arranged such that the device may be operated such that a pressure of one or more, preferably all, of the precursor gas flow A, the co-reactant gas flow B, the separator gas flow (S) flow, and combined separator-inhibitor gas flow (C) are at a pressure p which is within one order of magnitude around an ambient pressure (p_{amb}). Operating the device at a pressure around ambient pressure (0.1̇·p < p_{amb} < 10·p) allows use of the device in a continuous process flow, e.g. a reel-to-reel process flow, without a need for providing vacuum seals. In a preferred embodiment, a pressure at a downstream position along the drain x, e.g. downstream from an egress aperture in the process gas injection head 40, is comparatively low (i.e. lower than a pressure in the separator and deposition spaces), preferably by a factor of at least 2 or more, e.g. 10 or 100 or even 1000 or more.

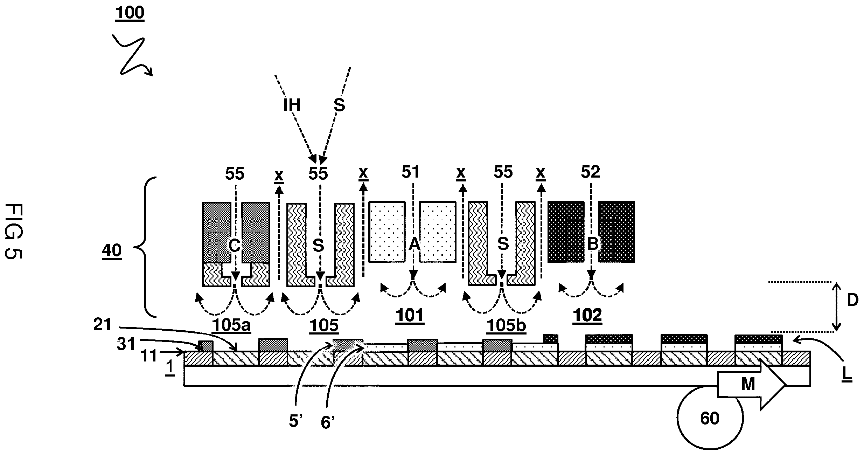

In a preferred embodiment, e.g. as shown in FIG 5, the atomic layer deposition device comprises a separator space 105c, provided between the first separator space 105a and the first deposition space 101. Although the device appears very similar to the embodiment as schematically depicted in FIG 3, the embodiment of FIG 5 differs therefrom in that the order in which the substrate surface is exposed to the separator gas flow S and combined separator-inhibitor gas flow C is reversed. The embodiment of FIG 5 may be specified as an atomic layer deposition device 100 for area-selective deposition of a target material layer L onto a deposition area 21 of a substrate surface 11 further comprising a non-deposition area 31, the device provided with at least a process gas injection head 40 and a conveying system 60 arranged to provide relative movement M between the substrate surface and the process gas injection head separated at a distance D therefrom in a direction along the substrate surface to form a conveying plane along which, in use, the substrate surface passes a plurality of deposition and separator spaces defined between the process gas injection head 40 and the substrate surface 11; the plurality of deposition and separator spaces including at least: first deposition space 101 provided with a precursor supply 51 and a precursor drain for providing a precursor gas flow A from the precursor supply via the first deposition space to the drain; and a second deposition space 102 provided with a co-reactant supply 52 and a co-reactant drain for providing a co-reactant gas flow B from the co-reactant supply via the second deposition space to the drain; and at least three separator spaces 105, 105a, 105b, wherein each of the at least three separator spaces is provided with at least a separator gas inlet 55 and a separator drain for providing a separator gas flow S from the separator gas inlet via the separator space to the drain; wherein a first gas separator space 105a of the at least three separator spaces is positioned adjacent to a third separator space 105 and wherein the first deposition space 101 is positioned adjacent to the third separation space opposite the first separator space 105a and wherein a second gas separator space 105b is positioned adjacent to the first deposition space 101 opposite the third gas separator space 105 and adjacent to the second deposition space 102 and wherein the process gas injection head is arranged to provide the first gas separator space 105a with a combined separator-inhibitor gas flow C comprising a separator gas and inhibitor moieties 5 selectively adhering to the non-deposition area.

In a particular embodiment the combined separator-inhibitor gas flow C is directly followed by a separator flow, i.e. with a separator gas flow S reducing intermixing of the precursor gas flow A and combined separator-inhibitor gas flow C. As such the head is or may be understood to be arranged to expose the substrate surface 11 to an atomic layer deposition process cycle PC formed of: an exposure to the combined gas-separator-inhibitor flow C, followed by an exposure to a first separator gas flow S, followed by an exposure to the precursor gas flow A, followed by an exposure to a second separator gas flow S, followed by an exposure to a co-reactant gas or plasma flow B, e.g. as depicted in FIG 5.

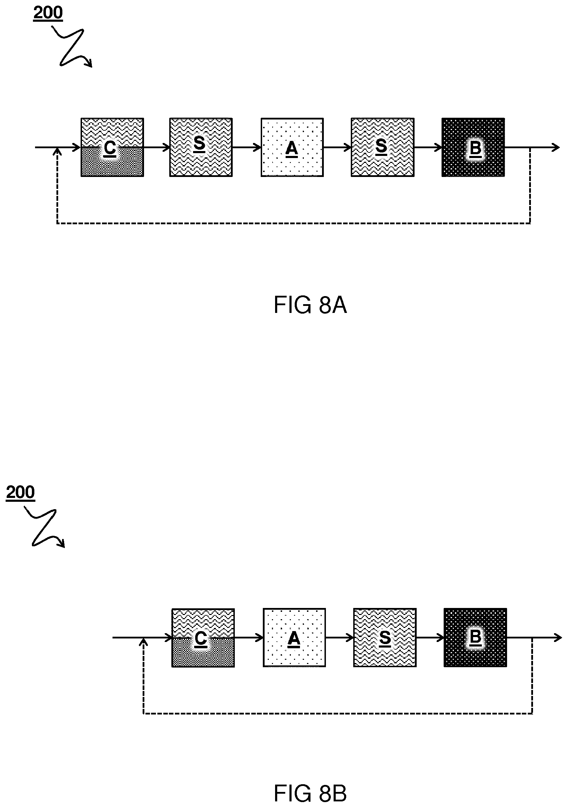

FIG 8A schematically illustrates a process cycle corresponding to an area selective atomic layer deposition method 200 in which a sample is exposed to a combined separator-inhibitor gas flow C before being exposed to a separator gas flow S, the precursor gas flow A, a further separator gas flow S and the co-reactant gas flow B.

By providing a device arranged to supply a separator gas flow S between the combined separator-inhibitor gas flow C and the precursor gas flow A mixing of inhibitor moieties 5 and precursor moieties 6 may be avoided, thereby avoiding possible adverse side-reactions. However, devices arranged such that a combined gas-separator-inhibitor flow C directly follows a co-reactant gas or plasma flow B of a preceding atomic layer deposition process cycle PC may be understood to be prone to intermixing of inhibitor and co-reactant moieties. Similarly to mixing of inhibitor moieties and precursor moieties 6 mixing of inhibitor and co-reactant moieties may lead to adverse side reactions. Inventors found that mixing of co-reactant and inhibitor may proceed in a non-harmful way, i.e. mixing may be acceptable for processes wherein the (one or more) inhibitor moiet(y)(ies) and the (one or more) co-reactant gas or plasma moiet(y)(ies) are mutually compatible. Mutually compatible may be understood to include mutually stable. For example, the inhibitor and co-reactant gas or plasma do not (or comparatively slowly in time scale of process) react with each other. Inventors found that in embodiments wherein the co-reactant is a plasma, undesired gas phase reactions with the inhibitor may advantageously be absent altogether. Inventors believe this may be explained by the short-lived nature of the highly reactive plasma species. In embodiments wherein the co-reactant gas or plasma flow B does not comprise plasma species formation of non-gaseous reaction products, e.g. formed from molecular co-reactant moieties, is preferably avoided. Non-gaseous reaction products may contaminate the substrate surface 11, and/or in/outlets of deposition spaces, separator spaces, and/or drains. Formation of gaseous or vapor phase reaction products may be tolerated as such products may be carried away from the substrate 1 in the exhausts (drains). In other words, in the gas phase the inhibitor and the co-reactant preferably do not (chemically) react. A reaction between the inhibitor and the co-reactant may be tolerated if reaction products may be carried away from the substrate in the exhaust, e.g. gaseous and/or vapor phase reaction products.

Devices and/or methods arranged to perform a process cycle wherein a combined gas-separator-inhibitor flow C directly follows a co-reactant gas or plasma flow B of a preceding atomic layer deposition process cycle PC are preferred over devices/methods wherein the substrate surface 11 is exposed to inhibitor in the gas separator directly before being exposed to the precursor, as inventors found that it offers more flexibility in terms of precursor and inhibitor choice. Furthermore, in embodiments wherein the co-reactant is a plasma the inhibitor is applied directly after a plasma treatment of the surface which may lead to increased inhibitor adsorption due to a plasma activation of the surface. In absence of a separation flow separating inhibitor and plasma flow chances of gas-phase reactions between inhibitor moieties and plasma species are believed to be highest towards the drain. Inventors find such reactions may be tolerated as formed by-products are typically volatile species which may be carried away and do not affect layer deposition in the deposition and non-deposition areas. For example, when using an O₂-plasma and acetlylacetone (Hacac) as inhibitor, combustion by-products are to be expected to include CO₂, CO, H₂O and the like. These by-products will be carried along with the flow and removed into the exhaust without harming the substrate surface 11. Similarly a broad range of inhibitor moieties may be used in processes employing H₂ plasmas. Inventors find that in such processes the by-products will mostly be formed by volatile CₓH_{y} species, e.g. CH₄ species. An exception here may be formed by inhibitor species formed by fluorinated molecules such as fluorinated alcohols (e.g., hexafluoroisopropanol (HFIP) which may lead to non-selective fluorocarbon deposition when interacting with H-plasma radicals.

In processes wherein non-plasma based co-reactants are used, no gas-phase reactions are expected on account of which the list of possible suitable inhibitors may be limited except for halogen-terminated inhibitors which may be subject to nucleophilic substitution with H₂O. For example chloroethane may be unsuitable as inhibitor moiety in processes in which inhibitor exposure is directly followed by an H₂O exposure.

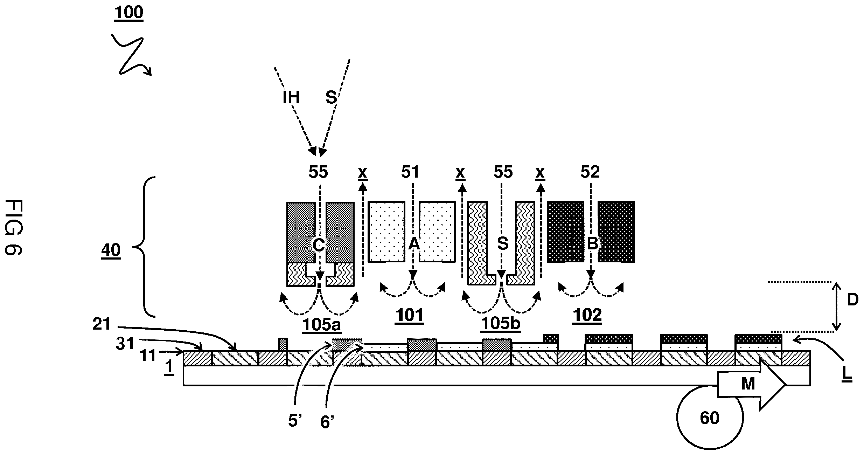

In a yet further particular embodiment, e.g. as shown in FIG 6, the process gas injection head is exactly arranged to expose the substrate surface 11 to an atomic layer deposition process cycle PC including: an exposure to the combined gas-separator-inhibitor flow C, followed by an exposure to the precursor gas flow A, followed by an exposure to a second separator gas flow S, followed by an exposure to a co-reactant gas or plasma flow B, e.g. as depicted in FIG 8B.

FIG 8B schematically illustrates a process cycle corresponding to an area selective atomic layer deposition method 200 in which a sample is exposed to a combined separator-inhibitor gas flow C before being exposed, the precursor gas flow A, a separator gas flow S and the co-reactant gas flow B.

Devices and/or methods arranged to perform a process cycle wherein a combined gas-separator-inhibitor flow C directly follows a co-reactant gas or plasma flow B of a preceding atomic layer deposition process cycle PC and is subsequently directly followed by an precursor gas flow A are preferably applied only when the inhibitor moiet(y)(ies) are preferably compatible with both the (one or more) co-reactant gas or plasma moiet(y)(ies) and the precursor moieties. As described before mutually compatibility may be understood to include mutually stable. As such the embodiment wherein a combined gas-separator-inhibitor flow C directly follows a co-reactant gas or plasma flow B of a preceding atomic layer deposition process cycle PC and is subsequently directly followed by an precursor gas flow A may be understood to be the cross-section of the embodiments prone to some intermixing between inhibitor moieties 5 and precursor moieties 6 and embodiments prone to some intermixing of inhibitor moieties 5 and co-reactant moieties 7, e.g. as in embodiments depicted in FIGs 3 and 5, respectively.

Compared to embodiments employing two separator gas flows and one combined separator-inhibitor gas flow (two separator spaces and one combined separator-inhibitor space), e.g. devices as depicted in FIG 3 and 5, a further improvement in process speed and/or reduction in device dimensions may be obtained for process wherein a combined gas-separator-inhibitor flow C directly follows a co-reactant gas or plasma flow B of a preceding atomic layer deposition process cycle PC and is subsequently directly followed by an precursor gas flow A.

For embodiments using a combined gas-separator-inhibitor flow C compared to embodiments using a dedicated inhibitor flow flanked by dedicated separator gas flows S on either side inventors found an approximate reduction of inert gas usage of about 16 %. Further the deposition rate was found to increase by a factor of about 1.2.

For embodiments wherein a combined gas-separator-inhibitor flow C directly follows a co-reactant gas or plasma flow B of a preceding atomic layer deposition process cycle PC compared to embodiments using a dedicated inhibitor flow inventors found an approximate reduction of inert gas usage of about 33%. Further the deposition rate was found to increase by a factor of about 1.5.

As used herein the deposition rate R may be understood to be defined as a measured increase in layer thickness per completed process cycle per cycle time.

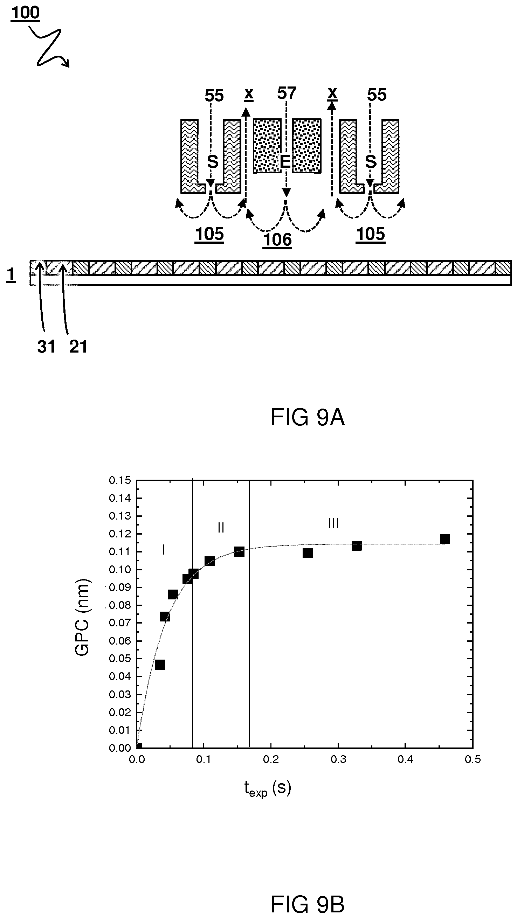

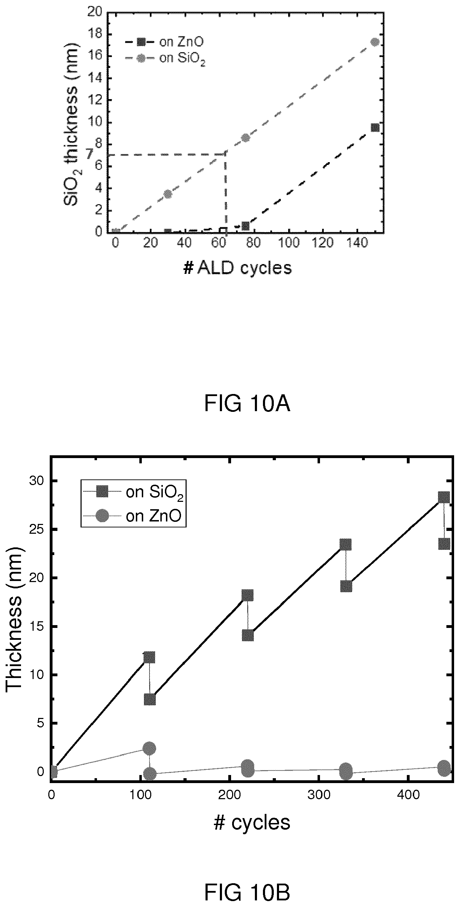

Inventors found that upon repeated exposure of a substrate surface 11 to the process cycles as described herein may, over time, result in a comparatively slow deposition of matter on the non-deposition area 31 of the substrate. Such undesirable deposition may be due to processing of samples with imperfect inhibition layers, for example as a result of contamination. Alternatively or in addition, such layers may be a result of what is known in the field as an unavoidable CVD, e.g. by gas-phase intermixing of precursor co-reactant moieties and uncontrolled deposition thus formed reaction products. FIGs 9A&B; 10A&B.

In a preferred embodiment the atomic layer deposition device comprises an etching space, e.g. as shown in Fig 9A.Inventors found that by providing an etching space, e.g. exposing the substrate to an etchant, material layers and/or contamination deposited on non-deposition areas may advantageously be removed. Thereby the selectivity of the deposition process can be improved. Inventors found that exposure to an etchant at regular intervals may remove material layers and/or contamination deposited on non-deposition areas, without substantially degrading deposited layers on target deposition areas. By providing the process gas injection head with an etching space, layers and/or contamination on non-deposition areas may be removed in an in-line fashion as will be explained in relation to the method and as illustrated in the examples.

FIG 9A illustrates a cross-sectional partial side view of an embodiment of an atomic layer deposition device including an etching space 106 provided with an etchant supply 57 and a drain for providing an etchant flow E from the etchant supply 57 via the etching space 106 to the drain. For clarity reasons other separation spaces and deposition spaces are omitted. It will be appreciated that the etching space 106 may be added to any one or more of the embodiments of the atomic layer deposition devices and methods described herein. For example, the etching space 10 may be added to the embodiments as described with reference to FIGs 2, 3, 5 and 6. It will likewise be appreciated that the etching space 106 may be provided by a separated injector, e.g. as described with reference to FIG 4.

Including an etching space 106 in to the atomic layer deposition device 100 may advantageously allow in-line removal of such undesired matter, e.g. layers deposited non-deposition areas 31. Exposing the substrate surface 11 to an etchant flow E may also result in a partial back-etch of the target layer L. It will be appreciated that the etching space 106 space is properly arranged such that upon repeated exposure of the substrate surface 11 to an atomic layer deposition process cycle PC including a back-etching step there remains a net-growth rate of the target layer L at the pre-defines deposition area 21. Proper arrangement may be achieved e.g. by suitably dimensioning of the etching space and/or by selection of proper process conditions, including but not limited to etchant concentration, temperature and exposure time. In a preferred embodiment, the etching space 106 is flanked by separator spaces 105 to avoid lateral spreading of etchant moieties and/or gas phase intermixing of etchant moieties with reactive moieties comprised in adjacent deposition spaces.

According to a second aspect the present disclosure relates to a method for area-selective deposition of a target material layer onto a deposition area of a substrate surface further comprising a non-deposition area. The method comprising:
- providing a substrate including a substrate surface comprising at least one deposition area and at least one non-deposition area;
- providing an atomic layer deposition device including a process gas injection head and a conveying system;
- providing relative movement between the substrate 1 and the process gas injection head,
wherein the substrate surface is separated at a distance from the process gas injection head and the movement is in a direction along the substrate surface to form a conveying plane along which the substrate surface passes a plurality of deposition and separator spaces defined between the process gas injection head and the substrate surface; the plurality of deposition and separator spaces including at least:
- a first deposition space provided with a precursor supply and a precursor drain,
- a second deposition space provided with a co-reactant supply and a co-reactant drain and
- at least two separator gas spaces wherein each of the at least two separator gas spaces is provided with at least a separator gas inlet and a separator gas drain,
wherein a first separator gas space of the at least two separator gas spaces is positioned adjacent to the first deposition space and wherein a second separator gas space is positioned adjacent to the first deposition space opposite the first separator gas space and adjacent to the second deposition space and wherein the process gas injection head is arranged to provide the first separator gas space with a combined separator-inhibitor gas flow comprising a separator gas and inhibitor moieties 5 selectively adhering to the non-deposition area;
- providing a precursor gas flow to the precursor supply,
- providing a co-reactant gas flow to the co-reactant supply;
- providing a combined separator-inhibitor gas flow to the separator gas inlet of first gas separator space of the at least two separator spaces; and
- providing a separator gas flow to the separator gas inlet of the second separator gas space and further separator gas spaces, if any, of the at least two separator spaces.

In a preferred embodiment, the atomic layer deposition device is an atomic layer deposition device according to the first aspect of the present disclosure.

By providing the specified relative movement and by providing the respective gas flows the substrate surface is exposed to the inhibitor moieties, precursor, co-reactant moieties in a way such as to complete a reaction between co-reactant and adsorbed precursor moieties forming an atomic layer of target material, i.e. complete an ALD process cycle, e.g. as shown in FIGs 7A&B and 8A&B.

In some embodiments, the method includes patterning the substrate surface to form the deposition and non-deposition area. Alternatively or in addition, the substrate may be provided pre-patterned, e.g. as a result or intermediary product in a preceding manufacturing process. It will be appreciated that the method and device according to the present disclosure may be understood to be mutually compatible. That is the device is preferably arranged to performed the herein described process cycles and method steps and vice versa, the method may be understood to be particularly suitable to be executed on the devices describe herein. Accordingly the device and methods share described benefits. Features described in relation to certain embodiments of the device may be similarly applied to the method. For example, where for the device it is described that the device may be understood to form a spatial ALD device (sALD), likewise the method be understood to pertain to a sALD process.

Similarly in a preferred embodiment, the separator gas flow in use at least contributes to separating the process gas injection head and the substrate surface. Preferably, a pressure generated by the combined separator and precursor and co-reactant gas flows essentially contributes to separating and/or maintaining a separation distance between the process gas injection head and the substrate surface.

Likewise, the relative motion is preferably repeated a pre-determined plurality of times such as to repeatedly expose the substrate to an ALD process cycle, e.g. as indicated by the dashed arrows in FIGs 7A-B and 8A-B. By repeating the relative motion the substrate may be exposed to a plurality of process cycles to increase a thickness of the formed target material layer L. As described in relation to the device the relative motion is preferably arranged such that the substrate during subsequent passes is exposed to the plurality of deposition and separation gas spaces in the same order as in a preceding pass. Alternatively, as described herein above, the relative motion may be a back-and-forth type motion.

In a preferred embodiment, the method further comprises an etching step. In a preferred embodiment, the etching step comprises exposing the substrate surface to an etchant flow at an etching space. The etching space may be integrated or added to the process gas injection head and is preferably provided with an etchant supply and a drain for providing an etchant flowing from the etchant supply via the etching space to the drain. In some embodiment the etchant flow is applied after each target material layer deposition cycle. In a preferred embodiment, the etching step is only applied after completing a pre-defined number of process cycles, e.g. after completing 25, 50, 100 or 200 cycles or multitudes thereof, e.g. after every 50, 100 or more cycles.

In other or further preferred embodiments an exposure of the substrate surface to inhibitor moieties comprised in the combined gas-separator-inhibitor flow is performed in a saturated or over saturated regime. A typical ALD saturation curve, e.g. as shown in FIG 9B, can be divided into three regions: In one extreme (region I) the surface is far from being in a saturation regime. It is believed that in this regime the exposure conditions, e.g. concentration, temperature and/or exposure time, are such that a substantial fraction of the available binding sites on the surface remains available, i.e. not all possible binding sites have reacted with a reactive moiety, e.g. inhibitor or precursor moieties. Operation in regime I (in undersaturation) is believed to lead to the formation of target material layers with less than theoretical expected thickness increase per process cycle (GPC) and/or incorporation of inhomogeneities, e.g. thickness, poor conformality, pinholes. Typically this regime is not used for ALD. The other extreme (region III) may be referred to as a regime in which the surface sites are saturated. This regime may be experimentally identified, e.g. as shown in FIG 10A by a leveling-off of a layer thickness growth per cycle (GPC) and may be defined as an exposure condition, e.g. exposure time, wherein the GPC is at least 95% of the GPC at complete saturation. In the example in Fig 10A this corresponds to exposure times in excess of about 0.17 seconds. Operation in this regime may lead to deposition of a target material layer L with excellent uniformity and conformal coverage even in (3D) high aspect ratio substrate topologies. According to the present disclosure exposure conditions are set, i.e. the device is operated, such that inhibitor exposure is preferably within region III.

In another or further preferred embodiment, the exposure of precursor and/or co-reactant is in region II (near-saturation), which may be characterized by a GPC which is in a range between about 50 and 95 %, preferably in a range between about 75 and 95 %, or higher, e.g. about 85 to 95 %, of the GPC at complete saturation.

Exposure of the substrate surface 11 to the inhibitor moieties comprised in the combined gas-separator-inhibitor flow C in a saturated regime was found to result in a good trade-off between uniform deposition, very high throughput and efficient blocking of the precursor on the non-deposition area 31. Advantageously this may result in an improved method in which comparatively thicker layers may be selectively deposited to pre-defined deposition areas 21. Exposure of the substrate surface to precursor and/or co-reactant moieties in a near saturation regime was found to result in a good trade-off between uniform deposition, very high throughput and efficient raw material usage. Accordingly, in a preferred embodiment, the exposure of the substrate surface 11 to the precursor and/or co-reactant moieties comprised in the precursor gas flow A and co-reactant gas flow B respectively, is in an intermediate regime below the saturated regime. It will be appreciated that although FIG 9B correlates GPC to an exposure time, those skilled in the art will understand that the actual exposure is defined by the product of partial pressure of the distinct chemicals and exposure time. Accordingly, exposure may be understood to be the product of partial pressure and exposure time.

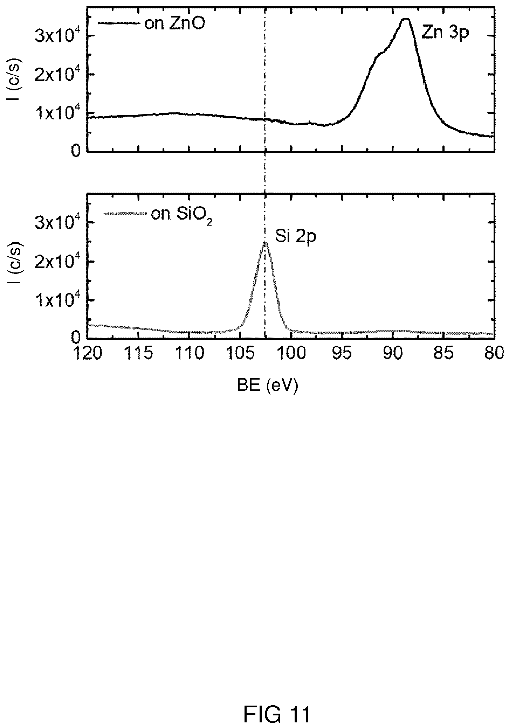

Now with reference to FIGs 10 and 11 there is provided experimental evidence of area-selective deposition of a target material layer onto a deposition area 21 of a substrate surface 11 using devices and methods as described herein. With reference to Fig 10A, a layer of silicon oxide was deposited onto an exemplary substrate comprising zinc oxide (ZnO) and silicon oxide (SiO₂) terminated surface area using a spatial ALD setup (sALD) according to the first aspect of the resent disclosure. To avoid deposition on the ZnO terminated areas inhibitor moieties 5 selectively binding to ZnO were employed. The thickness of the SiO₂ layer on the deposition area (SiO₂) was found to increase steadily with increasing number of ALD cycles. Up to about 65 process cycles no target material was observed on the non-deposition area (ZnO). At this point the total thickness of deposited SiO₂ amounted to approximately 7 nm. After about 80 process cycles SiO₂ was found to be deposited on ZnO terminated areas as well.

Fig 10B relates to a similar experiment but including an exposure to an etchant after about every 110 ALD process cycles, (110, 220, 330, and 440). Each etchant step reduces a thickness of a deposited SiO₂ layer by about 5 nm while a thickness of deposited SiO₂ on ZnO-terminated surface regions is reduced below a detection limit. As shown inclusion of the etchant step allows area-selective deposition of SiO₂ layer with increasing thickness beyond a level at which area unselective deposition would occur for methods not including an etching step.

FIG 11 shows X-ray photoelectron spectroscopic data evidencing area-selective deposition of SiO₂. As shown in the top-curve the spectrum recorded at the non-deposition areas at binding energies (BE) between 80 and 120 eV only shows peaks characteristic to a presence of Zn species whereas the bottom curve (recorded at target deposition areas) does show the presence of silicon species as expected.

As used herein precursor or precursor moiety may be understood to include any compound, e.g. molecules, able to participate in a self-limiting reaction with reactive groups (e.g. sites) on a surface. As known in the field such precursor moieties are typically metal species comprising a central metal ion surrounded by ligands. A broad variety of precursor compounds is known in the field including but not limited to metal-halides such as aluminum chloride and hafnium chloride, and metal-organic species including but not limited to metal-alkyls, such as trimethyl aluminum and diethylzinc; -carbonyls, such as iron(0)pentacarbonyl; -alkoxides, such as titanium(IV)isopropoxide; -alkylamides, such as pentakis(dimethylamino)tantalum(V); -cyclopentadienyls, such as cobaltocene; -β-diketonates, -amidinates, and -guadinates including bis(t-butylacetoacetato)copper(II), bis(N,N'-di-sec-butylacetamidinato)dicopper(I), and tris(1,3-diisopropyl-2-dimethylaminoguadinarto)gadolinium(III).

As used herein the co-reactant may be understood to include any moiety, e.g. as known in the field of ALD, to react with an adsorbed precursor moiety. As usual in the field such moieties may be provided in a vapor or gaseous state comprised in a stream of one or more inert carriers gasses to form a co-reactant gas flow (B). Co-reactant moieties include molecular species such as water and or oxygen which may react, e.g. in a ligand exchange reaction, with adsorbed precursor moieties. Typically, for gaseous or vapor phase co-reactants temperature in the deposition space may be raised to speed up the reaction to (near) completion. Suitable temperatures in the deposition space are found to be at least 50 °C, preferably in a range between 100 °C and 500 °C. Depending on reactivity and substrate stability reaction temperature may be adjusted, e.g. in a range between 350 °C and 500 °C, e.g. 380 °C. Alternatively or in addition co-reactant may be understood to include reactive plasma species. The plasma may be a remotely generated plasma, e.g. generated at an upstream position and transported to the reaction space by a carrier flow.

It will be appreciated that the precursor and/or co-reactant may be comprised of a mixture of precursor-, respectively, co-reactant moieties.

In ALD processes the precursor and/or co-reactant moieties are typically provided to in a flow, i.e. a precursor flow or co-reactant flow, essentially formed of an inert carrier gas mixed with a pre-determined amount (partial pressure) of the precursor moiet(y)(ies), respectively the co-reactant moiet(y)(ies).

Depending on the nature of the ALD process suitable inert gasses typically include di-nitrogen, argon, other noble gasses or mixtures thereof. In ALD processes wherein the co-reactant is a reactive plasma, e.g. an oxygen plasma, noble gasses or mixtures thereof are preferably employed as carrier and separation gas streams.

For the purpose of clarity and a concise description, features are described herein as part of the same or separate embodiments, however, it will be appreciated that the scope of the invention may include embodiments having combinations of all or some of the features described. For example, while embodiments were shown for a head formed of separate adjacent injectors, also alternative ways may be envisaged by those skilled in the art having the benefit of the present disclosure for achieving a similar function and result. E.g. injectors and/or heads may be combined or split up into one or more alternative components. The various elements of the embodiments as discussed and shown offer certain advantages, such as area-selective deposition in a continuous production process and/or production processes requiring a reduced amount of inert gasses. Of course, it is to be appreciated that any of the above embodiments or processes may be combined with one or more other embodiments or processes to provide even further improvements in finding and matching designs and advantages.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. An atomic layer deposition device (100) for area-selective deposition of a target material layer (L) onto a deposition area (21) of a substrate surface (11) further comprising a non-deposition area (31),
the device provided with at least a process gas injection head (40) and a conveying system (60) arranged to provide relative movement (M) between the substrate surface and the process gas injection head separated at a distance (D) therefrom in a direction along the substrate surface to form a conveying plane along which, in use, the substrate surface passes a plurality of deposition and separator spaces defined between the process gas injection head (40) and the substrate surface (11); the plurality of deposition and separator spaces including at least:
∘ a first deposition space (101) provided with a precursor supply (51) and a precursor drain for providing a precursor gas flow (A) from the precursor supply via the first deposition space to the drain; and
∘ a second deposition space (102) provided with a co-reactant supply (52) and a co-reactant drain for providing a co-reactant gas flow (B) from the co-reactant supply via the second deposition space to the drain; and
∘ at least two separator spaces (105) wherein each of the at least two separator spaces is provided with at least a separator gas inlet (55) and a separator drain for providing a separator gas flow (S) from the separator gas inlet via the separator space to the drain;
wherein a first gas separator space (105a) of the at least two separator spaces is positioned adjacent to the first deposition space (101) and wherein a second gas separator space (105b) is positioned adjacent to the first deposition space (101) opposite the first gas separator space (105a) and adjacent to the second deposition space (102) and wherein the process gas injection head is arranged to provide the first gas separator space (105a) with a combined separator-inhibitor gas flow (C) comprising a separator gas and inhibitor moieties (5) selectively adhering to the non-deposition area.

2. The atomic layer deposition device (100) according to claim 1, wherein the process gas injection head is formed of an assembly of a plurality of injectors arranged adjacent to each other.

3. The atomic layer deposition device (100) according to claim 1 or 2, wherein the gas separator flow, in use, at least contributes to separating the process gas injection head (40) and the substrate surface (11).

4. The atomic layer deposition device (100) according to any of the preceding claims, comprising a plurality of the deposition and separator spaces according to any of the preceding claims, such as to deposit a plurality of target material layers (L) upon a single pass of the substrate (1).

5. The atomic layer deposition device (100) according to any of the preceding claims, wherein one or more adjacent spaces share a drain (x).

6. The atomic layer deposition device (100) according to any of the preceding claims, wherein a pressure of one or more of the precursor gas flow (A), the co-reactant gas flow (B), the separator gas flow (S) flow, and combined separator-inhibitor gas flow (C) are at a pressure p which is within one order of magnitude around an ambient pressure (p_{A}) (0.1·p<p_{A} < 10·p)

7. The atomic layer deposition device (100) according to any of the preceding claims comprising a third separator space (105), wherein the third separator space is provided between the first separator space (105a) and the first deposition space (101).

8. The atomic layer deposition device (100) according to any of the preceding claims, wherein the device comprises an etching space (106) provided with an etchant supply (57) and a drain for providing an etchant flow (E) from the etchant supply (57) supply via the etching space (106) to the drain.

9. A method (200) for area-selective deposition of a target material layer (L) onto a deposition area (21) of a substrate surface (11) further comprising a non-deposition area (31), the method comprising:
- providing a substrate (1) including a substrate surface (11) comprising at least one deposition area (21) and at least one non-deposition area (31);
- providing an atomic layer deposition device (100) including a process gas injection head (40) and a conveying system (60);
- providing relative movement between the substrate (1) and the process gas injection head (40), wherein the substrate surface (11) is separated at a distance (D) from the process gas injection head and the movement is in a direction along the substrate surface to form a conveying plane along which the substrate surface passes a plurality of deposition and separator spaces defined between the process gas injection head (40) and the substrate surface (11); the plurality of deposition and separator spaces including at least:
∘ a first deposition space (101) provided with a precursor supply (51) and a precursor drain
∘ a second deposition space (102) provided with a co-reactant supply (52) and a co-reactant drain and
∘ at least two separator gas spaces (105) wherein each of the at least two separator gas spaces is provided with at least a separator gas inlet (55) and a separator gas drain,
wherein a first separator gas space (105a) of the at least two separator gas spaces is positioned adjacent to the first deposition space (101) and wherein a second separator gas space (105b) is positioned adjacent to the first deposition space (101) opposite the first separator gas space (105a) and adjacent to the second deposition space (102) and wherein the process gas injection head is arranged to provide the first separator gas space (105a) with a combined separator-inhibitor gas flow (C) comprising a separator gas and
inhibitor moieties (5) selectively adhering to the non-deposition area;
- providing a precursor gas flow (A) to the precursor supply (51)
- providing a co-reactant gas flow (B) to the co-reactant supply (52);
- providing a combined separator-inhibitor gas flow (C) to the separator gas inlet (55) of first gas separator space (105a) of the at least two separator spaces (105); and
- providing a separator gas flow (S) to the separator gas inlet (55) of the second separator gas space (105a) and further separator gas spaces, in any, of the at least two separator spaces (105).

10. The method according to claim 9, wherein the separator gas flow in use at least contributes to separating the process gas injection head (40) and the substrate surface.

11. The method according to any of the preceding claims, wherein the relative motion is repeated a pre-determined plurality of times.

12. The method according to any of the preceding claims, further comprising an etching step.

13. The method according to any of the preceding claims, wherein an exposure of the substrate surface (11) to inhibitor moieties comprised in the combined gas-separator-inhibitor flow (C) is in a saturated or over-saturated regime.

14. The method according to any of the preceding claims, wherein an exposure of the substrate surface (11) to the precursor and/or co-reactant moieties comprised in the precursor gas flow (A) and co-reactant gas flow (B) respectively, is in an intermediate regime below the saturated regime.

15. Use of a gas bearing to expose the substrate surface (11) to a combined gas-separator-inhibitor flow (C).
